# EUROPEAN PATENT APPLICATION

(11) **EP 1 945 009 A2**
(43) Date of publication of application: **16.07.2008**
(21) Application number: 07008867.9
(22) Date of filing: 02.05.2007
(51) Int. Cl.: H05K 1/02, H05K 3/30, H05K 7/20

(54) **Combination assembly of led and liquid-vapor thermally dissipating device**

(30) Priority: 12.01.2007 CN 200710003718
(71) Applicant: Tai-Sol Electronics Co., Ltd., Neihu District Taipei City 114 (TW)
(72) Inventor: Lai, Yaw-Huey, Jhonghe City Taipei County 235 (TW)
(74) Representative: Becker Kurig Straus

(57) **Abstract**

A combination assembly of LED and liquid-vapor thermally dissipating device (10) includes a liquid-vapor thermally dissipating device (11) including a metal shell (12) with capillarity structures therein and at least one LED unit (21) provided on the metal shell (12) of the liquid-vapor thermally dissipating device (11). The LED unit (21) includes a LED chip (22) with two electrode plates (221) at a top thereof and an insulating layer (222) at a bottom thereof to be mounted on the metal shell (12) of the liquid-vapor thermally dissipating device (11), two wires (24), an insulating plate (26), two transmitting plates (28) provided on the insulating plate (26), two wires (24) connecting the electrode plates (221) and the transmitting plates (28) respectively and an encapsulant (29) partially encapsulating the insulating plate (26) and the transmitting plates (28). The heat of the LED unit (21) may be transmitted to the liquid-vapor thermally dissipating device (11) directly for heat transmission. The present invention provides a greater heat transmission efficiency.

## Description

### BACKGROUND OF THE INVENTION

### 1. Field of the Invention

The present invention relates generally to a light emitting diode (LED), and more particularly to a combination assembly of LED and liquid-vapor thermally dissipating device, which has a greater performance in heat transmission.

### 2. Description of the Related Art

In present days, the high luminance LED produces high temperature, and there is no fine solution to fix it yet.

U.S. Patent no. 5,173,839 provides a heat transmission technique of a LED display. It provides a stack of a belt, an aluminum block, a belt and a heat sink under a LED chip to transmit the heat out. However, this technique provides three intermediates between the LED chip and the heat sink, which is the one performing heat transmission, that make the heat transmission rate is poor because the intermediates cause a greater heat resistance.

Taiwan Patent no. M295889 provides another heat transmission technique of LED. It provides a LED on a heat pipe. The LED includes a LED plastic insulating circuit board, a LED chip base, a LED heat chip and a LED lens. However, this technique provides the heat pipe, which has a high efficiency of heat transmission, to be the main for heat transmission, but there are also intermediates, the LED chip base and the LED plastic insulating circuit board, therebetween. These intermediates also cause the problem of high heat resistance and low heat transmission rate.

### SUMMARY OF THE INVENTION

The primary objective of the present invention is to provide a combination assembly of LED and liquid-vapor thermally dissipating device, which has a greater heat transmission performance for the LED.

According to the objective of the present invention, a combination assembly of LED and liquid-vapor thermally dissipating device includes a liquid-vapor thermally dissipating device including a metal shell with capillarity structures therein and at least one LED unit provided on the metal shell of the liquid-vapor thermally dissipating device. The LED unit includes a LED chip with two electrode plates at a top thereof and an insulating layer at a bottom thereof to be mounted on the metal shell of the liquid-vapor thermally dissipating device, two wires, an insulating plate, two transmitting plates provided on the insulating plate, two wires connecting the electrode plates and the transmitting plates respectively and an encapsulant partially encapsulating the insulating plate and the transmitting plates. The heat of the LED unit may be transmitted to the heat sink directly for heat transmission. The present invention provides a greater heat transmission efficiency.

### BRIEF DESCRIPTION OF THE DRAWINGS

FIG 1 is a perspective view of a first preferred embodiment of the present invention;
FIG 2 is a top view of the first preferred embodiment of the present invention;
FIG 3 is a sectional view along the 3-3 line of FIG. 2;
FIG 4 is a perspective view of a second preferred embodiment of the present invention;
FIG 5 is a perspective view of a third preferred embodiment of the present invention;
FIG 6 is a top view of the third preferred embodiment of the present invention;
FIG 7 is a sectional view along the 7-7 line of FIG 6; and
FIG 8 is a perspective view of a fourth preferred embodiment of the present invention.

### DETAILED DESCRIPTION OF THE INVENTION

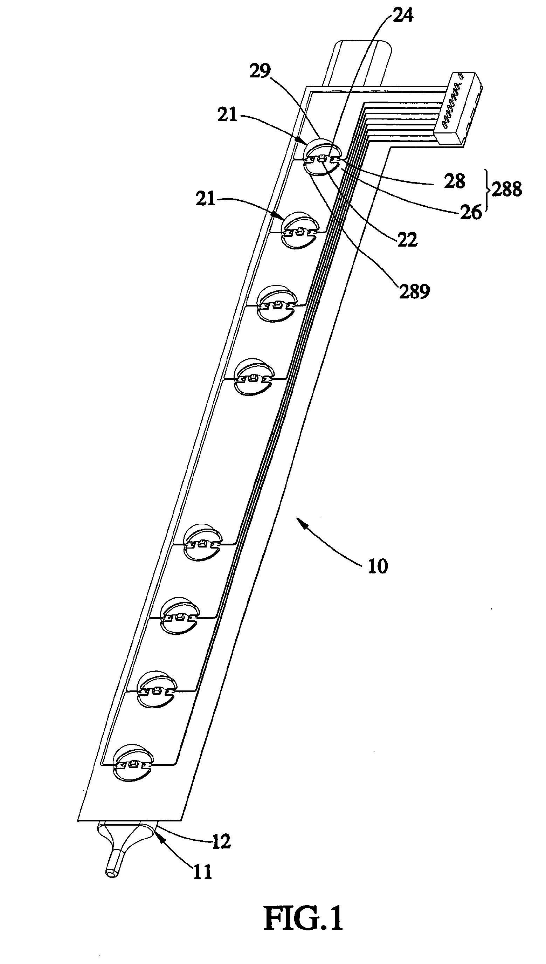

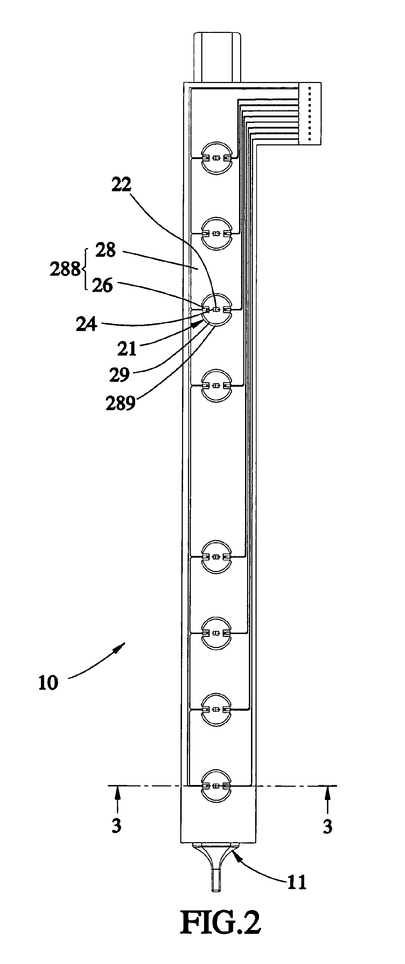

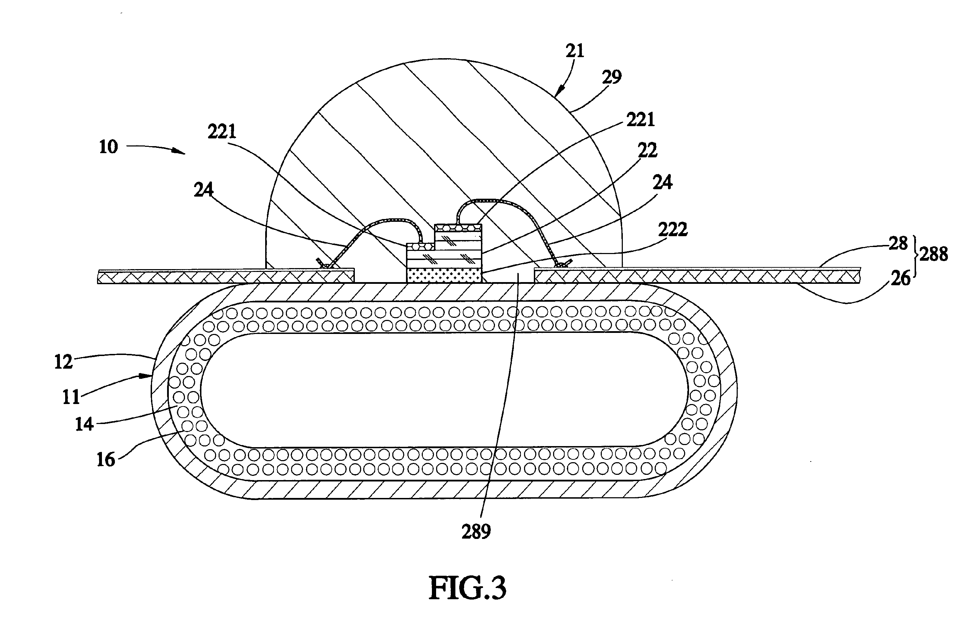

As shown in FIG 1 to FIG 3, a combination assembly of LED and liquid-vapor thermally dissipating device 10 of the first preferred embodiment of the present invention mainly includes a liquid-vapor thermally dissipating device 11 and a plurality of LED units 21.

The liquid-vapor thermally dissipating device 11 includes a metal shell 12, which is a copper heat pipe in the present embodiment, liquid 14 in the metal shell 12 and a capillarity structure 16. The capillarity structure 16 may be sinter copper powder or a web-like structure or slots on an interior side of the metal shell 12. The liquid-vapor thermally dissipating device 11 is a conventional device, and we'll not describe the detail here.

The LED units 21 are mounted on the metal shell 12 of the liquid-vapor thermally dissipating device 11.

The characters of the present invention are described hereunder:

The LED units 21 are arranged in series on the liquid-vapor thermally dissipating device 11.

Each of the LED units 21 main includes a LED chip 22, two wires 24, an insulating plate 26, three transmitting plates 28 and an encapsulant 29. The LED chip 22 has two electrode plates 221 at a top thereof and an insulating layer 222 at a bottom thereof. The insulating layer 222 is mounted on the metal shell 12 of the liquid-vapor thermally dissipating device 11. The insulating plate 26 is rested on the metal shell 12, and the transmitting plates 28 are mounted on the insulating plate 26. The wires 24 are connected to the electrode plates 221 and the transmitting plates 28 respectively. The encapsulant 29, which is transparent or semi-transparent doped with fluorescent powder, encapsulates the wires 24 and the LED chip 22 and encapsulates parts of the insulating plate 26 and the transmitting plate 28 also.

The insulating plate 26 and the transmitting plate 28 of the LED unit 21 may be formed by corresponding amounts of transmitting plate 28 on the same insulating plate 26 and integrated to form a circuit board 288. The circuit board 288 has a plurality of bores 289 arranged in series to receive the LED chips 22 therein respectively, and the two transmitting plates 28 are at opposite sides of the LED chip 22 respectively.

With the structure above, the electrode plates 221 of the LED chip 22 are electrically connected to the transmitting plates 28 of the circuit board 288 through the wires 24 that the transmitting plates 28 provides power to light the LED chip 22.

In operation of the first embodiment, there is an electronic driving device (not shown) connected to the circuit board 288 to supply power and light the LED chips 21 through the corresponding transmitting plates 28. The heat generated by the lighting LED chips 21 is transmitted to the metal shell 12 directly for heat transmission by the liquid-vapor thermally dissipating device 11, which has a high heat transmission efficiency, that the heat of the LED chips 21 may be transferred out quickly to provide a great heat transmission performance. In addition, each of the LED chips 22 has the insulating layer 222 at the bottom thereof to insulate the LED chips 22 from the metal shell 12 of the liquid-vapor thermally dissipating device 11 that the LED chips 22 will work normal without being affected by the metal shell 12.

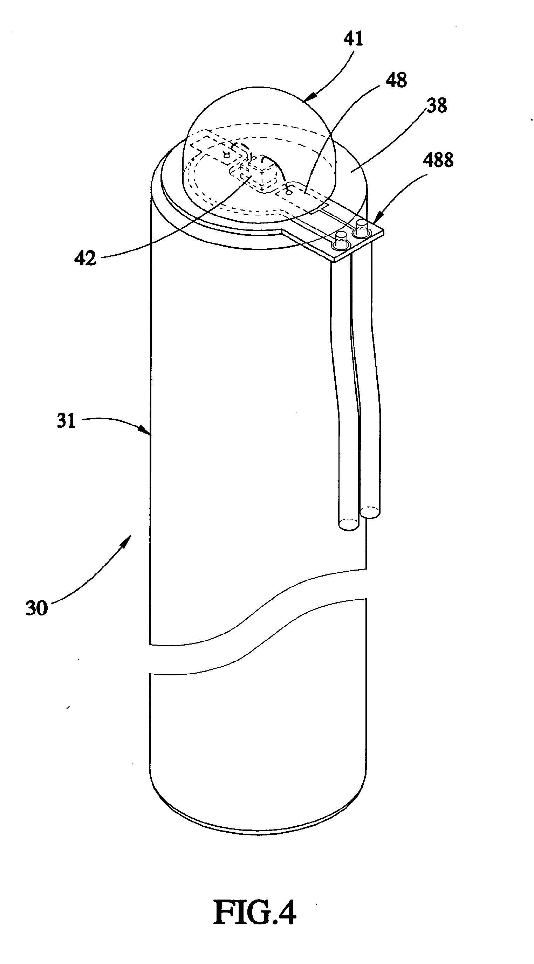

As shown in FIG 4, a combination assembly of LED and liquid-vapor thermally dissipating device 30 of the second preferred embodiment of the present invention, which is similar to the assembly 10 of the first embodiment, except that:

A liquid-vapor thermally dissipating device 31 has an end face 38, on which a LED chip 41 is provided. In addition, a circuit board 488 is a curved member surrounding the LED chip 42. Two transmitting plates 48 are at opposite sides of the LED chip 42.

Electricity supplied to the transmitting plates 488 will light the LED chips 42, and the liquid-vapor thermally dissipating device 31 transfers the heat of the lighting LED chips 42 out.

The operation mode and functions of the second embodiment are as same as the first embodiment, and we will not describe it again.

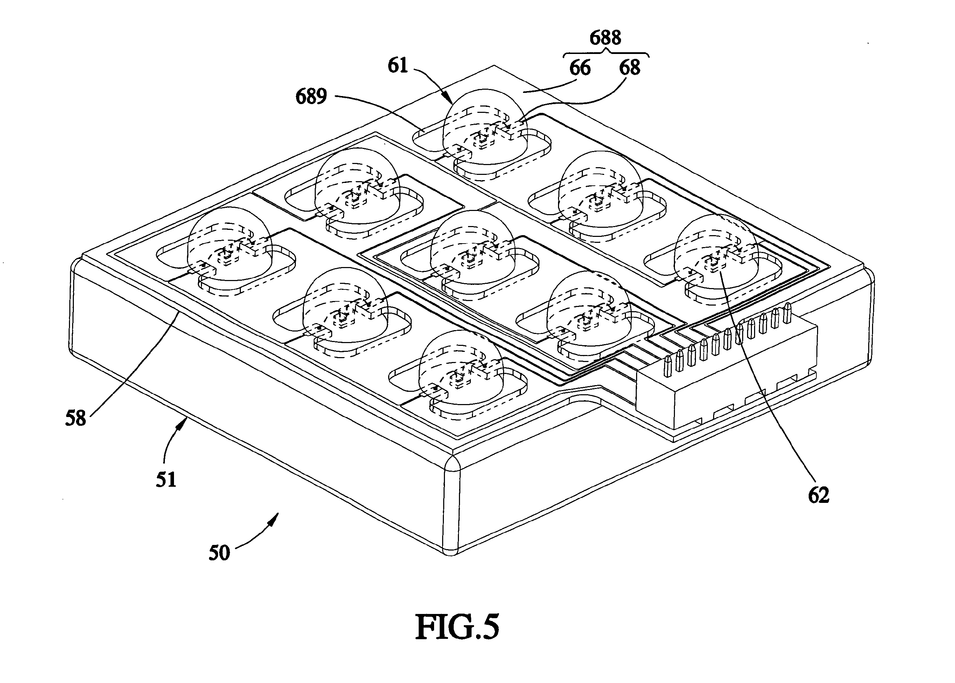

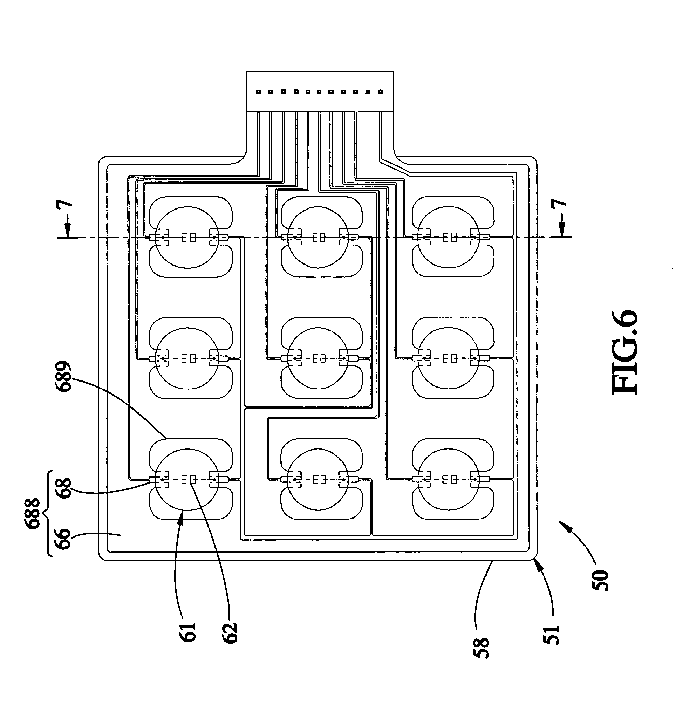

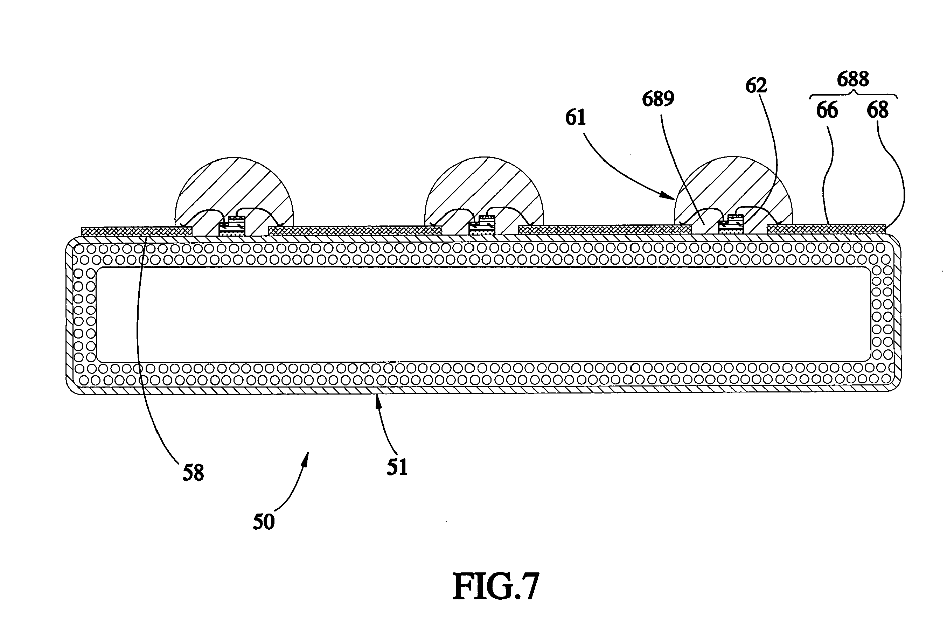

As shown in FIG 5 to FIG 7, a combination assembly of LED and liquid-vapor thermally dissipating device 50 of the third preferred embodiment of the present invention, which is similar to the assembly 10 of the first embodiment, except that:

A liquid-vapor thermally dissipating device 51 is a plate like member having a flat surface 58.

A plurality of LED units 61 is arranged on the flat surface 58 of the liquid-vapor thermally dissipating device 51 in matrix. Each of the LED units 61 has an insulating layer 66 and transmitting plates 68, which are formed by the corresponding amounts of the transmitting plate on the insulating plate 66 and integrated to form a circuit board 688. The circuit board 688 forms a plurality of bores 689, which arranged in matrix, to receive LED chips 62 therein respectively.

The rest structure, operation mode and functions of the third embodiment are as same as the first embodiment, and we will not describe it again.

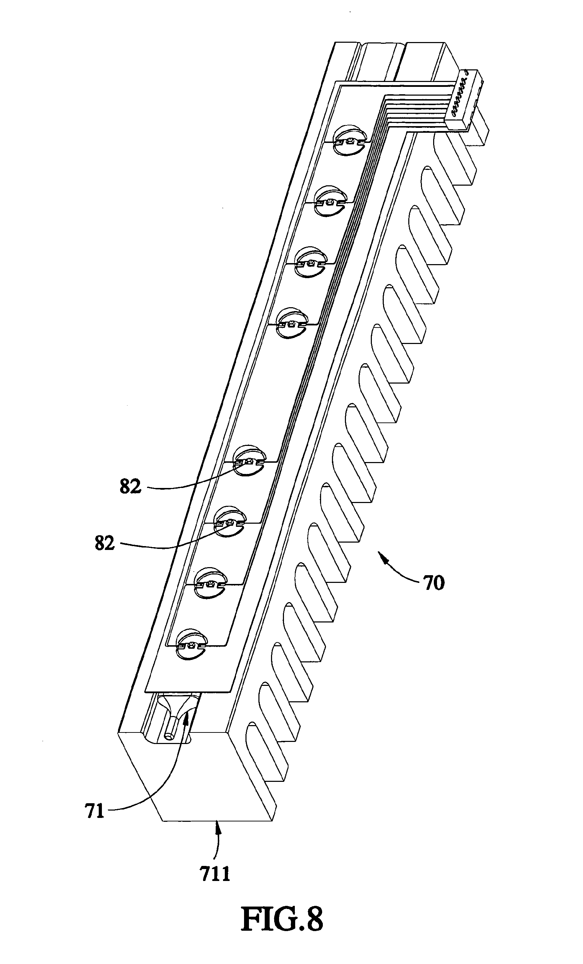

As shown in FIG 8, a combination assembly of LED and liquid-vapor thermally dissipating device 70 of the fourth preferred embodiment of the present invention, which is similar to the assembly 10 of the first embodiment, except that:

A liquid-vapor thermally dissipating device 71 is connected to a heat sink 711.

As a result, the heat generated by lighting LED chips 82 is transmitted to the heat sink 711 through the liquid-vapor thermally dissipating device 71 for heat transmission by a greater size of the heat sink 711.

The operation mode and functions of the second embodiment are as same as the first embodiment, and we will not describe it again.

In conclusion, the advantages of the present invention are:

To compare with the prior art, the present invention has no intermediate between the LED chips and the liquid-vapor thermally dissipating device, so that the present invention has less heat transmission resistance. The present invention provides the LED chips mounted on the liquid-vapor thermally dissipating device directly so that the heat of the LED chips may be transmitted to the liquid-vapor thermally dissipating device directly for heat transmission that has a greater performance of heat transmission than the prior art.

The description above is a few preferred embodiments of the present invention and the equivalence of the present invention is still in the scope of the claim of the present invention.

## Claims

1. A combination assembly of LED and liquid-vapor thermally dissipating device (10), comprising:
a liquid-vapor thermally dissipating device (11) including a metal shell (12) with capillarity structures (16) therein; and
at least one LED unit (21) provided on the metal shell (12) of the liquid-vapor thermally dissipating device (11);
wherein the LED unit (21) includes a LED chip (22) with two electrode plates (28) at a top thereof and an insulating layer (222) at a bottom thereof to be mounted on the metal shell of the liquid-vapor thermally dissipating device (11), two wires (22), an insulating plate (26), two transmitting plates (28) provided on the insulating plate (26), the wires (22) connecting the electrode plates (28) and the transmitting plates (28) respectively and an encapsulant (29) partially encapsulating the insulating plate (26) and the transmitting plates (28).

2. The combination assembly of LED and liquid-vapor thermally dissipating device (10) as defined in claim 1, wherein the insulating plate (26) and the transmitting plates (28) are integrated to form a circuit board (288).

3. The combination assembly of LED and liquid-vapor thermally dissipating device (10) as defined in claim 2, wherein the liquid-vapor thermally dissipating device (11) is a heat pipe.

4. The combination assembly of LED and liquid-vapor thermally dissipating device (10) as defined in claim 3, wherein there are a plurality of the LED units (21) arranged on the liquid-vapor thermally dissipating device (11) in series, and the insulating plates (26) of the LED units (21) and the transmitting plates (28) are integrated to form the circuit board (288).

5. The combination assembly of LED and liquid-vapor thermally dissipating device (10) as defined in claim 4, wherein the circuit board (288) has a plurality of bores (289) to receive the LED chips (21) therein, and the two transmitting plates (28) of each of the LED chips (22) are at opposite sides of the bore (289).

6. The combination assembly of LED and liquid-vapor thermally dissipating device (30) as defined in claim 3, wherein the liquid-vapor thermally dissipating device (31) has an end face (38), on which the LED chip (41) is provided.

7. The combination assembly of LED and liquid-vapor thermally dissipating device (30) as defined in claim 6, wherein the two transmitting plates (48) of each of the LED units (21) are at opposite side of the LED chip (41).

8. The combination assembly of LED and liquid-vapor thermally dissipating device (50) as defined in claim 2, wherein the liquid-vapor thermally dissipating device (51) has a flat surface (58).

9. The combination assembly of LED and liquid-vapor thermally dissipating device (50) as defined in claim 8, wherein there are a plurality of the LED units (61) arranged on the flat surface (58) of the liquid-vapor thermally dissipating device (51) in matrix, and the insulating plates (66) of the LED units (61) and the transmitting plates (66) are integrated to formed the circuit board (688).

10. The combination assembly of LED and liquid-vapor thermally dissipating device (50) as defined in claim 9, wherein the circuit board (688) has a plurality of bores (689) arranged in matrix, and the LED chips (62) are received in the bores (689) respectively.

11. The combination assembly of LED and liquid-vapor thermally dissipating device (70) as defined in claim 1, wherein the liquid-vapor thermally dissipating device (71) is connected to a heat sink (711).
